(19) **Europäisches Patentamt / European Patent Office / Office européen des brevets**

(11) **EP 3 729 917 B1**

(12) **FASCICULE DE BREVET EUROPEEN**

(45) Date de publication et mention de la délivrance du brevet:
**04.02.2026 Bulletin 2026/06**

(21) Numéro de dépôt: **18811554.7**

(22) Date de dépôt: **03.12.2018**

(51) Classification Internationale des Brevets (IPC):
*H05K 1/11* (2006.01)    *H05K 3/34* (2026.01)
*H05K 3/30* (2026.01)

(52) Classification Coopérative des Brevets (CPC):
**H05K 3/3442; H05K 1/111;** H05K 3/305;
H05K 2201/068; H05K 2201/09472;
H05K 2201/09663; H05K 2201/10636; Y02P 70/50

(86) Numéro de dépôt international:
**PCT/EP2018/083369**

(87) Numéro de publication internationale:
**WO 2019/120969 (27.06.2019 Gazette 2019/26)**

(54) **SUPPRESSION DES ZONES DE FORTE CONTRAINTE DANS LES ASSEMBLAGES ÉLECTRONIQUES**

ENTFERNUNG VON HOCHSPANNUNGSZONEN BEI ELEKTRONISCHEN BAUGRUPPEN

REMOVAL OF HIGH STRESS ZONES IN ELECTRONIC ASSEMBLIES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.12.2017 FR 1762467**

(43) Date de publication de la demande:
**28.10.2020 Bulletin 2020/44**

(73) Titulaire: **SAFRAN ELECTRONICS & DEFENSE**
**92100 Boulogne Billancourt (FR)**

(72) Inventeurs:
• CHOCTEAU, Philippe
92100 Boulogne - Billancourt (FR)
• LECORDIER, Denis
92100 Boulogne - Billancourt (FR)

(74) Mandataire: **Regimbeau**
**20, rue de Chazelles**
**75847 Paris Cedex 17 (FR)**

(56) Documents cités:
JP-A- 2016 178 150     US-A- 5 569 880
US-A- 5 684 677     US-A1- 2008 180 926
US-A1- 2015 342 045     US-A1- 2017 150 605
US-A1- 2017 208 689

**Description**

DOMAINE DE L'INVENTION

L'invention concerne le domaine des cartes électroniques, notamment dans les domaines de l'automobile, de l'aéronautique et du spatial, et plus précisément la fixation de composants montés en surface sur des circuits imprimés.

ARRIERE-PLAN TECHNOLOGIQUE

De manière connue en soi, une carte électronique peut comprendre des composants montés en surface (CMS), c'est-à-dire des composants électroniques brasés directement à la surface du circuit imprimé d'une carte électronique.

Habituellement, les CMS sont montés en surface soit par refusion (« reflow soldering » en anglais), soit à la vague (« solder wave » en anglais), soit par l'utilisation d'une colle conductrice, soit par frittage.

Dans le cas du brasage par refusion, le circuit imprimé nu est tout d'abord sérigraphié en recouvrant les couches conductrices du circuit imprimé (généralement en cuivre) par une crème à braser à l'aide d'un écran de sérigraphie (ou pochoir) de sorte que seuls les emplacements destinés à recevoir les terminaisons des composants sont recouverts par la crème à braser. La crème à braser comprend, de manière connue en soi, un alliage métallique en suspension dans un flux de brasage. Puis les terminaisons des composants (CMS) sont posées sur la crème à braser avant de subir un traitement thermique de refusion, au cours duquel la chaleur fait refondre l'alliage et évaporer le flux de brasage de manière à former des joints de brasure à partir de l'alliage métallique présent dans la crème à braser.

Dans le cas d'un assemblage par frittage argent, le circuit imprimé nu est également sérigraphié en recouvrant les couches conductrices du circuit imprimé par une pâte à l'aide d'un écran de sérigraphie (ou pochoir) de sorte que seuls les emplacements destinés à recevoir les terminaisons des composants sont recouverts par la pâte. La pâte comprend, de manière connue en soi, des particules d'argent et des éléments organiques servant de liant, de dispersant et de diluant. Puis les terminaisons des composants (CMS) sont posées sur la pâte avant de subir un traitement thermique de frittage, au cours duquel la chaleur fait souder les grains entre eux sans les mener jusqu'à la fusion, réalisant ainsi le joint.

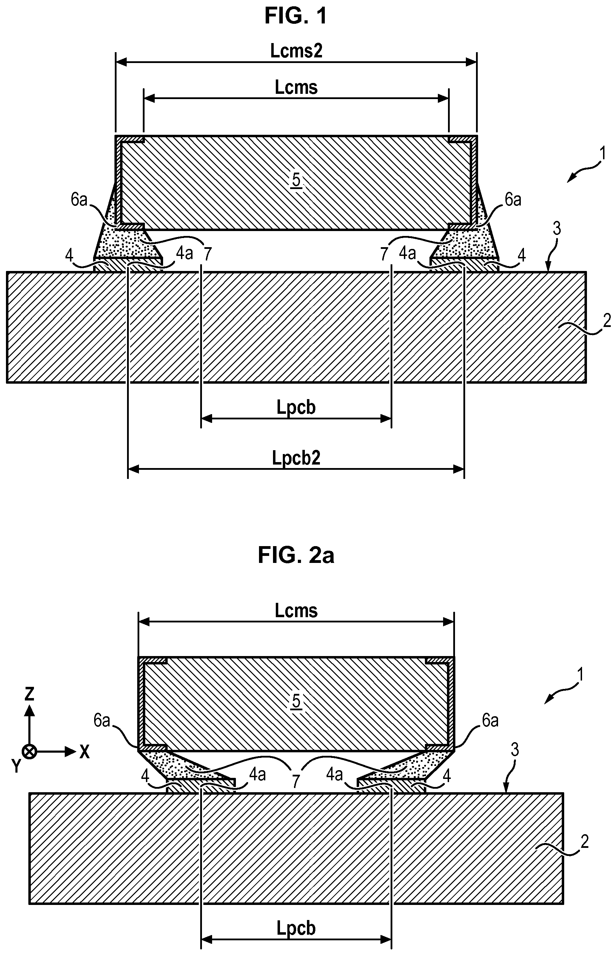

Les joints ainsi obtenus (que ce soit par brasage ou par frittage) sont cependant fortement sollicités. En particulier, la partie des joints qui est située entre le composant et la plage de brasage est très fine, comme on peut le voir en figure 1. Les joints subissent donc de très fortes contraintes, notamment en cisaillement, et risquent donc de se fissurer rapidement lorsque la carte électronique subit des environnements sévères en températures et/ou en vibrations. Cela réduit donc fortement la durée de vie de la carte électronique.

Par ailleurs, en utilisation, les cartes électroniques peuvent être soumises à des environnements sévères en températures créant des déplacements relatifs (dans le plan de la surface) entre CMS et le circuit imprimé. Ces déplacements relatifs sont généralement dus à une dilatation différentielle entre les CMS et le circuit imprimé résultant d'une variation de température, les CMS et le circuit imprimé ayant généralement des coefficients de dilatation thermique dans le plan différents. Or, ces déplacements relatifs ont pour effet de générer des contraintes qui endommagent les joints de brasure, limitant ainsi leur durée de vie et leur fiabilité.

Afin de réduire ces contraintes, il a été proposé d'augmenter la hauteur verticale (habituellement désignée par le terme anglais « standoff ») entre la face supérieure de la plage de brasage (qui peut être en cuivre, en cuivre recouvert de nickel-or au tout autre matériau adapté) et le point bas des terminaisons conductrices des CMS une fois brasés, afin d'augmenter la hauteur d'alliage en interface entre les CMS et les plages de brasage. Les joints de brasure ainsi obtenus sont alors plus souples et donc plus robustes.

Le document US 2017/150605 décrit un composant électronique fixé sur une plage dont une partie a été retirée afin de fixer la terminaison du composant électronique sur la partie exposée du substrat.

Le document US 2015/342045 décrit une carte électronique conforme au préambule de la revendication 1.

Toutefois, l'industrie de l'aéronautique et du spatial reste en perpétuelle recherche d'amélioration des cartes électroniques, et cherche donc encore des Inventions pour augmenter la fiabilité et la durée de vie des joints de brasure des CMS.

RESUME DE L'INVENTION

Un objectif de l'invention est donc de proposer une carte électronique comprenant un circuit imprimé et des composants montés en surface dont la durée de vie, la fiabilité et la robustesse sont améliorées, qui soit simple à réaliser et de coût modéré quelle que soit la densité d'implantation des composants sur le circuit imprimé et/ou le type de composant, sans pour autant impacter le rendement d'assemblage de la carte électronique et sans modifier le process d'assemblage usuellement utilisé.

Pour cela, l'invention propose une carte électronique conforme à la revendication 1. Des modes de réalisation sont décrits dans les revendications dépendantes.

BREVE DESCRIPTION DES DESSINS

D'autres caractéristiques, buts et avantages de la présente invention apparaîtront mieux à la lecture de la description détaillée qui va suivre, et au regard des dessins annexés donnés à titre d'exemples non limitatifs et sur lesquels :

La figure 1 illustre schématiquement un exemple de réalisation d'une carte électronique conforme à l'art antérieur,
La figure 2a est une vue schématique d'un exemple non revendiqué d'une carte électronique comprenant un composant monté en surface, dans le cas où la première distance est inférieure à la deuxième distance. La carte électronique est à température ambiante.
La figure 2b illustre la carte électronique lorsqu'elle subit une température sévère.
La figure 3 est une vue schématique d'un exemple de réalisation d'une carte électronique conforme à l'invention comprenant un composant monté en surface, dans le cas où la première distance est supérieure à la deuxième distance.
La figure 4 est une vue schématique d'un exemple de réalisation non revendiqué d'une carte électronique dans laquelle les plages ne s'étendent pas sur le côté du composant, dans lequel des cavités sont formées dans une couche isolante recouvrant en tout ou partie la face de connexion de la carte isolante et la première distance est inférieure à la deuxième distance.
La figure 5 illustre un exemple de réalisation non revendiqué d'une carte électronique dans laquelle les plages ne s'étendent pas sur le côté du composant, dans laquelle un point de colle est utilisé pour maintenir le composant électronique pendant son brasage sur le circuit imprimé,
Les figures 6a et 6b illustrent deux exemples de réalisation non revendiqués , dans lesquels le composant électronique est en outre fixé sur des plages de brasage sacrificielles.
Les figures 7a et 7b sont des vues schématiques du dessus illustrant une variante de réalisation non revendiquée, dans lesquelles les plages de brasage sacrificielles sont connectées aux plages de brasage par l'intermédiaire d'une ou de deux bandes de connexion.

DESCRIPTION DETAILLEE D'UN MODE DE REALISATION

Une carte électronique 1 comprend un circuit imprimé 2 comportant des couches conductrices séparées par des couches isolantes sur lequel sont fixés des composants électroniques montés en surface 5 (ci-après, des CMS 5).

De manière générale, un circuit imprimé 2 peut être du type monocouche (également appelé simple couche) et ne comprendre qu'une seule couche conductrice sur une couche isolante, double couche (également appelé double face) et comprendre une couche conductrice de part et d'autre d'une couche isolante ou multicouche et comprendre au moins quatre couches conductrices (et donc trois couches isolantes).

Le circuit imprimé 2 présente une face de connexion 3 définissant un plan (X, Y) et destinée à recevoir au moins un CMS 5. A cet effet, la face de connexion 3 comporte au moins une plage 4. Par plage 4, on comprendra ici une plage, par exemple en cuivre, sur laquelle est brasé ou fritté le CMS 5.

Les CMS 5 quant à eux comprennent au moins une terminaison 6, chaque terminaison étant fixée sur une plage 4 associée de la face de connexion 3 du circuit imprimé 2 par l'intermédiaire d'un joint de brasure 7.

Dans ce qui suit, l'invention sera décrite dans le cas où le circuit imprimé 2 de la carte électronique 1 comprend deux plages de brasage 4, deux joints 7 de brasure et un CMS 5 comprenant deux terminaisons 6. Ceci n'est cependant pas limitatif, le circuit imprimé pouvant comprendre un plus grand nombre de plage de brasage 4, ou pouvant être obtenu par frittage et comportant alors des plages de frittage 4 et autant de joints 7 de frittage associés, la carte électronique 1 pouvant comprendre un plus grand nombre de CMS 5, et les CMS 5 un nombre différent de terminaisons (au moins une terminaison 6). L'invention s'applique alors mutatis mutandis à chaque ensemble formé des plages 4 (de brasage ou de frittage) et du CMS 5 associé.

L'invention s'applique également mutatis mutandis au frittage ou au brasage d'une puce sur un substrat dans un composant monté en surface, puisque lesdites puces forment elles-mêmes un composant monté en surface sur un circuit imprimé.

Afin d'améliorer la durée de vie de la carte électronique 1 et de réduire les contraintes dans les joints de brasure 7, la ou les plages de brasage 4 sont positionnées sur la face de connexion 3 du circuit imprimé 10 de sorte qu'une projection orthogonale des terminaisons 6 du composant électronique 5 sur la face de connexion 3 du circuit imprimé ne chevauche pas la ou les plages de brasage 4 associées. En d'autres termes, les plages de brasage 4 et les terminaisons 6 ne se chevauchent pas, de sorte que les plages de brasage 4 se trouvent de part et d'autre du CMS 5.

Cela permet donc de supprimer la zone du joint de brasure 7 qui est située entre une terminaison 6 donnée du CMS 5 et la plage de brasage 4 associée. Comme nous l'avons vu plus haut, cette zone, très fine (de l'ordre d'une dizaine de microns), correspondait en effet à l'endroit du joint de brasure 7 où les contraintes en cisaillement (et donc les risques de fissuration) sont les plus fortes dans un CMS fixé sur le circuit imprimé conformément à l'art antérieur (voir Fig. 1). Or en supprimant cette zone, on homogénéise les contraintes en cisaillement dans le joint de brasure 7 et limite les risques d'initiation de fissures, ce qui améliore encore une fois la durée de vie de l'assemblage du CMS.

Dans le cas où le circuit imprimé 10 et le CMS 5 présentent des coefficients de dilatation thermique dans le plan (X, Y) différents, la distance entre les plages de brasage 4 peut en outre être ajustée en fonction de la distance entre les terminaisons 6 du CMS et de la valeur de ces coefficients de dilatation thermique afin d'optimiser leur déplacement relatif lors de l'exposition de la carte électronique 1 à des conditions sévères en température et de soulager les joints de brasure 7.

En effet, les plages de brasage 4 du circuit imprimé sont séparées par une première distance $L_{PCB}$. Cette première distance $L_{PCB}$ est mesurée à température ambiante $T_1$ entre les centres 4a respectifs des plages de brasage 4.

Les terminaisons 6 sont quant à elles séparées par une deuxième distance $L_{CMS}$. Cette deuxième distance $L_{CMS}$ est mesurée à température ambiante $T_1$ entre les extrémités 6a respectives des terminaisons 6. Dans le cas où le CMS 5 comprend plus de deux terminaisons 6, la deuxième distance $L_{CMS}$ correspond à la distance entre les extrémités 6a des terminaisons 6 les plus éloignées, typiquement en diagonale. Par ailleurs, pour les CMS 5 dont les terminaisons comprennent des pattes, la distance $L_{CMS}$ s'étend depuis l'extrémité libre des pattes qui vient en regard des plages de brasage 4 et non depuis leur extrémité fixée sur le CMS.

Enfin, les joints de brasure 7 présentent une épaisseur cumulée $L_J$ mesurée à température ambiante $T_1$ entre leurs bords libres. Dans le cas où le CMS 5 comprend plus de deux terminaisons 6, l'épaisseur $L_J$ correspond à l'épaisseur cumulée des joints de brasure 7 entre les extrémités 6a des terminaisons 6 les plus éloignées, typiquement en diagonale du CMS 5.

L'allongement $\Delta L_{PCB}$ du circuit imprimé 2, l'allongement $\Delta L_{CMS}$ du CMS 5 et l'allongements $\Delta L_J$ en fonction de la température (ces allongements $\Delta L_{PCB}$, $\Delta L_{CMS}$ et $\Delta L_J$ pouvant être positifs et/ou négatifs) peuvent être évalués grâce aux relations suivantes :

$$\Delta L_{CMS} = L_{CMS} \times \Delta T \times CTE_{CMS}$$

$$\Delta L_{PCB} = L_{PCB} \times \Delta T \times CTE_{PCB}$$

$$\Delta L_J = L_J \times \Delta T \times CTE_J$$

où

$L_{PCB}$ est la première distance
$L_{CMS}$ est la deuxième distance
$L_J$ est l'épaisseur cumulée des joints de brasure 7
$\Delta T = T_2 - T_1$
$T_4$ est la température ambiante à laquelle sont déterminées les première et deuxième distances $L_{PCB}$, $L_{CMS}$. Par température ambiante $T_1$, on comprendra ici une température de l'ordre d'une vingtaine de degrés.
$T_2$ est une température différente de $T_1$, par exemple une température d'utilisation, de stockage ou de fonctionnement de la carte électronique 1,
$\Delta L_{CMS}$ est l'allongement du CMS 5 entre la température ambiante $T_1$ et la température $T_2$,
$\Delta L_{PCB}$ est l'allongement du circuit imprimé 2 entre la température ambiante $T_1$ et la température $T_2$,
$\Delta L_J$ est l'allongement des joints de brasure 7 entre la température ambiante $T_1$ et la température $T_2$.

La différence $\Delta L_{assemblage}$ entre l'allongement du CMS 5 et l'allongement du circuit imprimé 2, entre la température ambiante $T_1$ et la température $T_2$, peut donc être obtenue grâce à la formule (1) suivante :

$$\Delta L_{assemblage} = \left( L_{PCB} \times CTE_{PCB} - L_{CMS} \times CTE_{CMS} - L_J \times CTE_J \right) \times \Delta T$$

De plus, la distance $L_{PCB}$ est égale à la somme de la distance $L_{CMS}$ et de l'épaisseur cumulée $L_J$ des joints de brasure 7. On obtient donc la formule (2) suivante :

$$\Delta L_{assemblage} = \left( L_{PCB}(CTE_{PCB} - CTE_J) - L_{CMS}(CTE_{CMS} + CTE_J) \times \Delta T \right.$$

Il est ainsi possible d'augmenter de manière simple et efficace la durée de vie et la robustesse d'une carte électronique 1 en ajustant la première distance $L_{PCB}$ en fonction de la deuxième distance $L_{CMS}$ et des coefficients de dilatation thermique $CTE_{PCB}$, $CTE_J$ et $CTE_{CMS}$, grâce à la formule (1) reproduite ci-dessus. Quelle que soit la température de fonctionnement, la différence d'allongement $\Delta L_{assemblage}$ est donc optimisée de manière à être aussi faible que possible, limitant ainsi fortement les contraintes au sein des joints de brasure 7.

La deuxième distance $L_{CMS}$ étant fixe et intrinsèque au CMS 5, on ajuste donc la première distance $L_{PCB}$ en gravant les plages de brasage 4 sur la face de connexion 3 de sorte que la première distance $L_{PCB}$ permette de compenser l'écart de coefficient de dilatation thermique entre le circuit imprimé 2, les joints de brasure 7 et le CMS 5.

Idéalement, on cherche à avoir une différence d'allongement $\Delta L_{assemblage}$ nulle. Afin de réduire les contraintes formées au sein des joints de brasure 7 lors des variations de température, la première distance $L_{PCB}$ (entre les plages de brasage 4) est donc choisie de manière à être égale au quotient entre, d'une part, la différence entre le coefficient de dilatation thermique ($CTE_{CMS}$) du CMS et le coefficient de dilatation thermique des joints de brasure et, d'autre part, la différence entre le coefficient de dilatation thermique ($CTE_{PCB}$) du circuit imprimé et le coefficient de dilatation thermique des joints de brasure, le tout étant multiplié par la deuxième distance $L_{CMS}$ :

$$L_{PCB} = L_{CMS} \times \frac{CT_{CMS} - CTE_J}{CTE_{PCB} - CTE_J} \qquad (3)$$

On notera que l'invention trouve particulièrement une application lorsque la différence entre le premier coefficient de dilatation thermique ($CTE_{PCB}$) et le deuxième coefficient de dilatation thermique ($CTE_{CMS}$) est supérieure ou égale à 2. En dehors de cette gamme, la dilatation différentielle du CMS 5 et du circuit imprimé est en effet trop faible pour que le déplacement relatif du CMS 5 et du circuit imprimé soit notable.

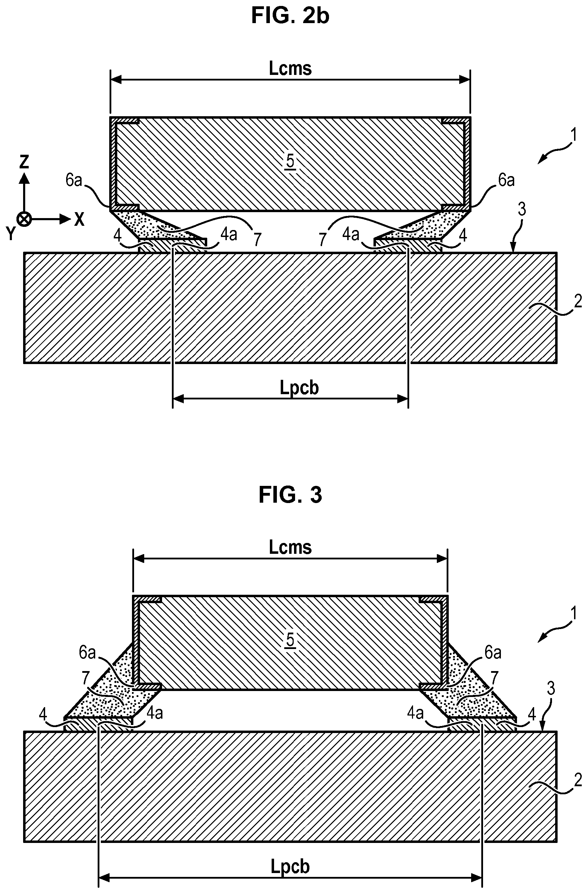

Ainsi, lorsque le coefficient de dilatation thermique $CTE_{CMS}$ du CMS 5 est inférieur au coefficient de dilatation thermique $CTE_{PCB}$ du circuit imprimé 2, qui est lui-même inférieur au coefficient de dilatation thermique $CTE_{joint}$ du joint 7 (cas de la grande majorité des CMS 5), on retrouve que la première distance $L_{PCB}$ est strictement supérieure à la deuxième distance $L_{CMS}$ (Figure 3) de sorte que les plages de brasage 4 se trouvent de part et d'autre à l'extérieur des terminaisons 6 du CMS 5. De la sorte, lorsque la carte électronique 1 subit une température $T_2$ supérieure à la température ambiante $T_1$, le CMS 5 et le circuit imprimé 2 se dilatent. Toutefois, le coefficient de dilatation thermique $CTE_{PCB}$ du matériau constitutif du circuit imprimé 2 étant supérieur à celui du CMS 5, le circuit imprimé 2 se dilate davantage que le CMS 5. La distance $L_{PCB}$ étant strictement supérieure à la deuxième distance $L_{CMS}$, il en résulte qu'à cette température $T_2$, les plages de brasage 4 et les terminaisons 6 du CMS 5 sont quasiment à la même distance relative qu'à température ambiante $T_1$, ce qui soulage les contraintes dans les joints de brasure 7 par rapport au cas où les plages de brasage 4 et les terminaisons 6 du CMS 5 sont en regard l'une de l'autre à température ambiante $T_1$ (Figure 1) et la distance relative entre elles varie plus sensiblement.

Ainsi, l'élévation de la température ne modifie pas le déplacement relatif entre les terminaisons 6 du CMS 5 et les plages de brasage 4 du circuit imprimé 2 et en réduit les effets négatifs en compensant la différence de dilatation du CMS 5, des joints 7 et du circuit imprimé 2.

En pratique, la durée de vie et la robustesse de la carte électronique 1 sont déjà nettement améliorés lorsque la première distance $L_{PCB}$ est égale, à 50% près, à la multiplication du quotient des différences de coefficients de dilatation thermique $\frac{CTE_{CMS} - CTE_J}{CTE_{PCB} - CTE_J}$ par la deuxième distance $L_{CMS}$ (formule (3) décrite ci-avant), tant que la projection orthogonale des terminaisons 6 ne chevauche pas la plage de brasage 4 associée. Cette tolérance de 50% est justifiée par les constatations suivantes :

- La terminaison du CMS 5 (respectivement, le circuit imprimé 2) présente un allongement $\Delta L_{CMS}$ (respectivement, $\Delta L_{PCB}$) variable entre ses deux extrémités (respectivement, entre les bords de la plage de brasage 4). Il n'est donc pas possible d'obtenir $L_{PCB} = L_{CMS} \times \frac{CTE_{CMS} - CTE_J}{CTE_{PCB} - CTE_J}$ partout dans le joint de brasure.

- Il n'est pas toujours possible de rapprocher suffisamment les plages de brasage 4 pour respecter la formule (3). Par exemple, si le coefficient de dilatation thermique du CMS 5 est deux fois plus grand que celui du circuit imprimé 2, il n'est pas possible de rapprocher suffisamment les plages pour respecter la formule (3) et de réaliser le joint de brasure lors de la fabrication de la carte électronique 1.

- Les coefficients de dilatation thermique du circuit imprimé, des joints de brasure 7 et du CMS ne sont généralement pas connus avec précision et ont une dispersion.

- Les coefficients de dilatation thermique du circuit imprimé, des joints de brasure 7 et du CMS varient en fonction de la température.

Par exemple, pour des circuits imprimés 2 simple face, le coefficient de dilatation thermique $CTE_{PCB}$ du circuit imprimé 2 est généralement compris entre 14 ppm/°C et 17 ppm/°C. Dans l'exemple ci-dessous, le circuit imprimé 2 présente un coefficient de dilatation thermique $CTE_{PCB}$ égal à 14 ppm/°C. Le joint de brasure 7 est réalisé dans un alliage sans plomb SAC305 dont le coefficient de dilatation thermique $CTE_J$ est de 23.5 ppm/°C. Le CMS5 est une résistance 2512 présentant une longueur de 6.3 mm de sorte que la deuxième distance $L_{CMS}$, qui correspond à la distance entre les extrémités 6a des terminaisons 6 de la résistance, est égale à 6.3 mm à température ambiante. Par ailleurs, le coefficient de dilatation thermique $CTE_{CMS}$ de la résistance est égal à 7. On cherche donc à écarter les plages de brasage 4 de sorte que la deuxième distance $L_{CMS}$, qui correspond à la distance entre les centres des plages de brasage 4, se rapproche de la valeur théorique que l'on obtient grâce à la formule (3), soit environ 10.9 mm :

$$L_{PCB} = 6.3 \times \frac{7 - 23.5}{14 - 23.5} = 10.9 \; mm$$

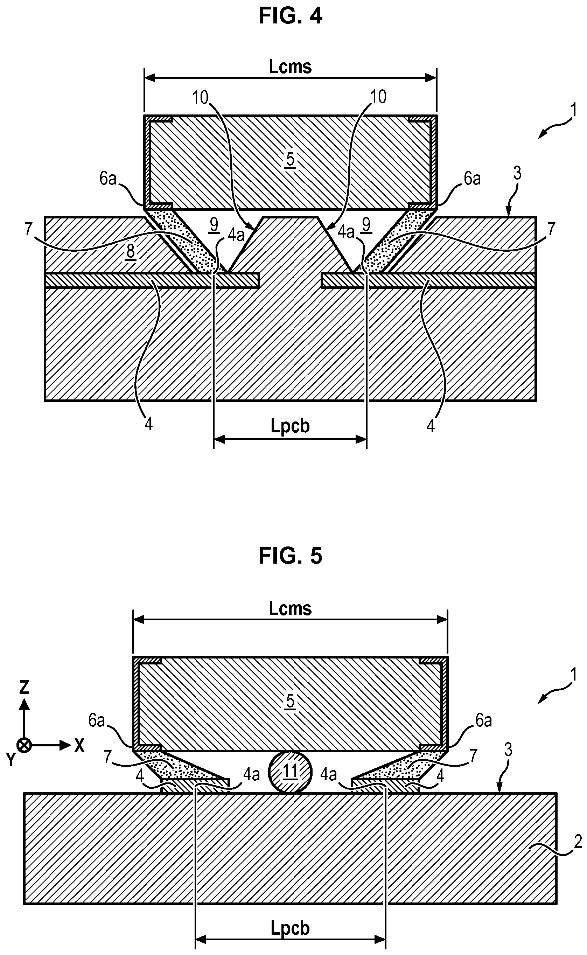

Dans une forme de réalisation, la carte électronique 1 peut en outre comprendre une couche isolante 8 recouvrant au moins partiellement la face de connexion 3 et deux cavités 9, formées dans la couche isolante et dévoilant au moins en partie les plages de brasage 4. Dans ce cas, le CMS 5 est en contact ou à distance de la couche isolante 8 et ses terminaisons 6 sont fixées aux plages de brasage 4 correspondantes à travers la première et la deuxième cavités 9.
Une telle forme de réalisation est décrite plus particulièrement dans la demande de brevet français n° 17 56700, déposée le 13 juillet 2017 au nom de la Demanderesse. La réalisation de telles cavités 9 permet en particulier d'augmenter de manière simple et peu coûteuse le standoff du CMS 5 sans pour autant impacter le rendement d'assemblage des CMS 5.
Dans une variante de cette forme de réalisation (Figure 4), la carte électronique 1 est multicouche et comprend au moins quatre couches conductrices séparées deux à deux par des couches isolantes, dont :

-    une première couche conductrice de peau fixée sur la couche isolante,
-    une première et une deuxième couches conductrices internes comprenant les deux plages de brasage 4.

Les deux cavités 9 sont alors formées dans la première couche conductrice de peau et dans la couche isolante.
On pourra notamment se référer à la demande de brevet français n° 17 56697, déposée le 13 juillet 2017 au nom de la Demanderesse. Une telle carte électronique 1 peut ainsi comprendre des CMS 5 variés, qu'il s'agisse de composants à pas fin, de grandes tailles, avec des pattes en ailes de mouette, etc., de manière simple et pour un coût modéré sans pour autant impacter le rendement d'assemblage des CMS 5.
Quelle que soit la variante de réalisation, la paroi 10 des cavités 9 peut être inclinée par rapport à la face de connexion 3. En variante, elle peut diverger. Selon une autre variante encore la paroi 10 des cavités 9 est perpendiculaire à la face de connexion 3. Dans cette dernière variante de réalisation, la surface dévoilée de la face de connexion 3 est donc plus grande que la surface des plages de brasage 4. Le cas échéant, la cavité 9 peut être plus grande suivant la direction principale de dilatation du CMS 5 que la plage de brasage 4. Pour cela, la couche isolante peut être pré-percée avant son assemblage avec le circuit imprimé 2. En variante, la plage de brasage 4 peut être réalisée de manière à être plus large que nécessaire dans cette direction, puis la cavité 9 peut être réalisée par photolithographie en surface comme décrit dans le document FR 17 56700 et la zone de la plage de brasage 4 superflue peut être retirée.
Lors de la fixation en automatique, notamment par refusion, d'un CMS 5 sur un circuit imprimé 2, il se peut que le CMS 5 ne soit pas centré et se déplace davantage vers l'une des terminaisons 6 en raison des forces de mouillage qui ne sont généralement pas équilibrées (le CMS 5 n'étant généralement pas placé exactement au milieu des deux plots de crème à braser).
En cas de déplacement du CMS 5, l'effet recherché n'est alors pas obtenu : typiquement, ce déplacement peut recréer une zone de fortes contraintes dans le joint de brasure 7 à la verticale entre une terminaison 6 donnée du CMS 5 et la plage de brasage 4 associée qui est propice à l'initiation de fissures et réduit donc la durée de vie du CMS. Pire encore, le CMS 5 peut se désolidariser de l'une des terminaisons 6 pendant le brasage.
Un mode de réalisation est proposé pour faciliter la fabrication des cartes électroniques 2 en automatique. Ce problème ne se pose en effet pas lors de la fixation manuelle du CMS 5.
Dans ce mode de réalisation (Fig. 5), un point de colle 11 est placé entre le CMS 5 et les plages de brasage 4 du circuit imprimé 2 préalablement à l'étape brasage. Un tel point de colle 11 suffit en effet pour maintenir le CMS 5 en position et lutter contre les forces de mouillage.
Typiquement, la colle 11 est choisie de manière à présenter une température de polymérisation inférieure à la température du traitement thermique utilisée lors du brasage du CMS 5. Par exemple, lorsque le CMS 5 est brasé par refusion d'une crème à braser, la colle est choisie de manière à présenter une température de polymérisation de l'ordre de 100°C à 150°C (pour rappel, un brasage par refusion comprend, de manière connue en soi, les étapes successives de montée en température, préchauffage, refusion et refroidissement, la température de l'étape de refusion étant généralement supérieure à 180°C). De la sorte, la colle polymérise pendant la phase de préchauffage et est capable de maintenir le CMS 5 en position pendant l'étape de refusion.

La colle peut par exemple être une colle époxy.

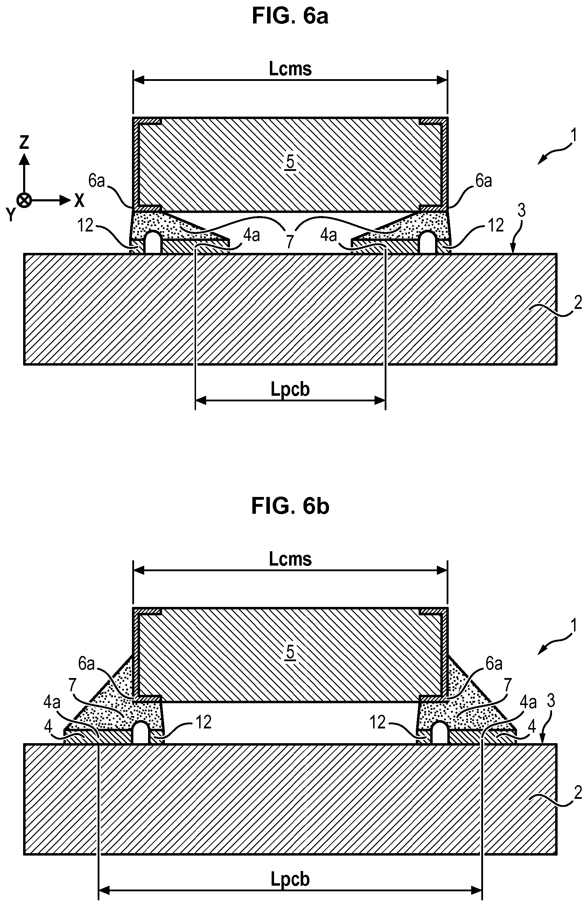

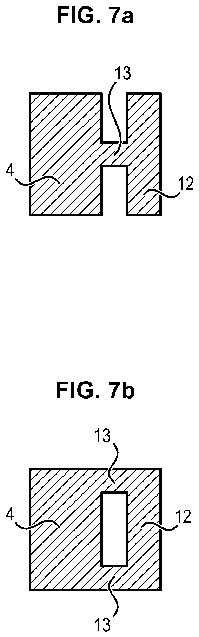

Dans un exemple non revendiqué (Figures 6a, 6b, 7a et 7b), une plage de brasage sacrificielle 12 est ajoutée, pour chaque terminaison 6 du CMS 5, entre la plage de brasage 4 et la partie du circuit imprimé 2 qui s'étend en regard de la terminaison 6 associée. La plage sacrificielle 12 peut être réalisée dans le même matériau que la plage de brasage 4 associée. Ainsi, les plages sacrificielles 12 peuvent être placées entre les plages de brasage 4 lorsque les plages de brasage 4 se trouvent sur l'extérieur du CMS 5.

De préférence, les plages de brasage sacrificielles 12 sont très fines (par exemple de l'ordre de deux cent microns) de façon à maintenir l'avantage lié au décalage des plages de brasage 4 par rapport au centre des terminaisons 6. Lorsque la carte électronique 1 subit un environnement thermique sévère, les contraintes en cisaillement vont alors se concentrer dans la partie du joint de brasure 7 qui est fixée sur les plages sacrificielles 12 et généralement les fissurer. Toutefois, ces plages sacrificielles 12 étant distinctes des plages de brasage 4, la fissuration ne va pas affecter la partie du joint de brasure 7 qui est fixée aux plages de brasage 4. On retrouvera donc une carte électronique 1 dans laquelle la projection orthogonale des terminaisons 6 ne chevauche pas les plages de brasage 4. En parallèle, les plages sacrificielles 12 sont capables de maintenir le CMS 5 en position et d'éviter qu'il ne se décale pendant son brasage sur le circuit imprimé 2.

La Demanderesse s'est aperçue que, dans de très rares cas, le CMS 5 pouvait tout de même se déplacer et n'être alors relié au niveau de l'une de ses terminaisons 6 qu'à l'une des plages sacrificielles 12. Afin de réduire encore les taux de défaut, pour chaque terminaison 6, la plage sacrificielle 12 et la plage de brasage 4 associées peuvent être reliées par une fine bande 13 réalisée dans le même matériau que la plage de brasage 4. Les déplacements inopinés du CMS 5 et du joint de brasure 5 pendant le brasage du CMS 5 sur le circuit imprimé sont alors encore plus rares. En cas de déplacement inopiné du CMS 5 et du joint de brasure 5 pendant le brasage du CMS 5 sur le circuit imprimé de sorte que le joint de brasure 7 ne soit plus en contact qu'avec la plage sacrificielle 12, la connexion électrique avec la plage de brasage 4 reste assurée grâce à la fine bande 13. La fine bande 13 peut être globalement centrée entre la plage sacrificielle 12 et la plage de brasage 4 (formant ainsi un H - Fig. 6a), ou s'étendre le long d'un bord de celles-ci (formant ainsi un U). En variante, deux bandes 13 peuvent s'étendre entre la plage sacrificielle 12 et la plage de brasage 4, par exemple au niveau de chacun des bords de la plage de brasage 4 (formant ainsi un O - Fig. 6b).

On notera que la forme et les dimensions de la plage de brasage sacrificielle 12 ne sont pas limitatives. En particulier, la plage de brasage sacrificielle 12 peut être plus longue ou plus courte que la plage de brasage 7, plus large ou plus étroite, sans que cela ne soit limitatif.

## Revendications

1. Carte électronique (1) comprenant :

   - un circuit imprimé (2) présentant une face de connexion (3) définissant un plan (X, Y) comportant deux plages (4) de brasage ou de frittage, lesdites plages (4) étant séparées d'une première distance ($L_{PCB}$) lorsque la carte électronique (1) est à température ambiante ($T_1$),
   - le circuit imprimé (2) présentant un premier coefficient de dilatation thermique ($CTE_{PCB}$) dans le plan (X, Y), et
   - un composant électronique (5) comportant au moins une terminaison (6), chaque terminaison (6) étant brasée ou frittée uniquement sur une plage (4) associée par l'intermédiaire d'un joint (7) de brasure ou de frittage, le composant électronique (5) comprenant deux terminaisons (6), lesdites terminaisons (6) étant séparées d'une deuxième distance ($L_{CMS}$) lorsque la carte électronique (1) est à température ambiante ($T_1$), le composant électronique (5) présentant un deuxième coefficient de dilatation thermique ($CTE_{CMS}$) dans le plan (X, Y), le joint de brasure (7) présentant un troisième coefficient de dilatation thermique ($CTE_J$) dans le plan (X, Y),
   dans laquelle chaque terminaison s'étend au-dessus et à distance de la plage (4) associée suivant une direction normale au plan (X, Y) et chaque plage (4) s'étend sur le côté du composant électronique (5),
   la carte électronique étant **caractérisée en ce qu'** une projection orthogonale de la terminaison (6) du composant électronique (5) sur la face de connexion (3) du circuit imprimé ne chevauche pas la plage (4) associée..

2. Carte électronique (1) selon la revendication 1, comprenant en outre :

   - une couche isolante (8) recouvrant au moins partiellement la face de connexion (3),
   - au moins une cavité (9) formée dans la couche isolante (8) et dévoilant au moins en partie la plage (4),

le composant électronique (5) étant en contact ou à distance de la couche isolante (8) et la terminaison (6) du composant électronique (5) étant fixée à la plage (4) correspondante à travers la cavité (9).

3. Carte électronique (1) selon la revendication 2, dans laquelle le circuit imprimé (2) comprend en outre au moins quatre couches conductrices séparées deux à deux par des couches isolantes, dont :

   - une première couche conductrice de peau fixée sur la couche isolante (8),
   - une première et une deuxième couches conductrices internes comprenant les deux plages (4), et
   - au moins deux cavités (9) formées dans la première couche conductrice de peau et dans la couche isolante (8).

4. Carte électronique (1) selon l'une des revendications 2 ou 3, dans laquelle la paroi (10) de la cavité (9) est sensiblement perpendiculaire à la plage (4).

5. Carte électronique (1) selon l'une des revendications 1 à 4, comprenant en outre un point de colle (11) sous le composant électronique (5), entre les plages (4), afin de maintenir le composant électronique (5) en position par rapport aux plages (4) lors du brasage du composant électronique (5) sur le circuit imprimé (2).

**Patentansprüche**

1. Elektronische Karte (1), umfassend:

   - eine Leiterplatte (2), die eine Verbindungsfläche (3) aufweist, die eine Ebene (X, Y) definiert, die zwei Löt- oder Sinterbereiche (4) aufweist, wobei die Bereiche (4) durch einen ersten Abstand ($L_{PCB}$) getrennt sind, wenn die elektronische Karte (1) Raumtemperatur ($T_1$) hat,
   wobei die Leiterplatte (2) einen ersten Wärmeausdehnungskoeffizienten ($CTE_{PCB}$) in der Ebene (X, Y) aufweist, und

   - ein elektronisches Bauteil (5), das mindestens einen Anschluss (6) aufweist, wobei jeder Anschluss (6) nur in einem Bereich (4) gelötet oder gesintert ist, der über eine Löt- oder Sinterverbindung (7) zugeordnet ist, wobei das elektronische Bauteil (5) zwei Anschlüsse (6) umfasst, wobei die Anschlüsse (6) durch einen zweiten Abstand ($L_{CMS}$) getrennt sind, wenn die elektronische Karte (1) Raumtemperatur ($T_1$) hat, wobei das elektronische Bauteil (5) einen zweiten Wärmeausdehnungskoeffizienten ($CTE_{CMS}$) in der Ebene (X, Y) aufweist, wobei die Lötverbindung (7) einen dritten Wärmeausdehnungskoeffizienten ($CTE_J$) in der Ebene (X, Y) aufweist,

   wobei sich jeder Anschluss oberhalb und beabstandet von dem Bereich (4) erstreckt, der gemäß einer senkrechten Richtung der Ebene (X, Y) zugeordnet ist und sich jeder Bereich (4) auf der Seite des elektronischen Bauteils (5) erstreckt,
   wobei die elektronische Karte **dadurch gekennzeichnet ist, dass** eine orthogonale Projektion des Anschlusses (6) des elektronischen Bauteils (5) auf der Verbindungsfläche (3) der Leiterplatte den zugehörigen Bereich (4) nicht überlappt.

2. Elektronische Karte (1) nach Anspruch 1, die ferner umfasst:

   - eine Isolierschicht (8), die die Verbindungsfläche (3) zumindest teilweise bedeckt,
   - mindestens einen in der Isolierschicht (8) ausgebildeten Hohlraum (9), der den Bereich (4) mindestens teilweise freigibt,

   wobei das elektronische Bauteil (5) in Kontakt mit der Isolierschicht (8) steht oder davon beabstandet ist und der Anschluss (6) des elektronischen Bauteils (5) durch den Hohlraum (9) hindurch an dem entsprechenden Bereich (4) befestigt ist.

3. Elektronische Karte (1) nach Anspruch 2, wobei die Leiterplatte (2) ferner mindestens vier leitende Schichten umfasst, die jeweils paarweise durch Isolierschichten getrennt sind, darunter:

   - eine erste leitende Deckschicht, die auf der Isolierschicht (8) befestigt ist,
   - eine erste und eine zweite innere leitende Schicht, die die beiden Bereiche (4) umfassen, und

- mindestens zwei Hohlräume (9), die in der ersten leitenden Deckschicht und in der Isolierschicht (8) ausgebildet sind.

4. Elektronische Karte (1) nach einem der Ansprüche 2 oder 3, wobei die Wand (10) des Hohlraums (9) im Wesentlichen senkrecht zu dem Bereich (4) ist.

5. Elektronische Karte (1) nach einem der Ansprüche 1 bis 4, die ferner einen Klebepunkt (11) unter dem elektronischen Bauteil (5) zwischen den Bereichen (4) umfasst, um das elektronische Bauteil (5) beim Löten des elektronischen Bauteils (5) auf die Leiterplatte (2) relativ zu den Bereichen (4) in Position zu halten.

**Claims**

1. An electronic board (1) comprising:

   - a printed circuit (2) having a connection face (3) defining a plane (X, Y) including two solder or sintering pads (4), said pads (4) being separated by a first distance ($L_{PCB}$) when the electronic board (1) is at ambient temperature ($T_1$),
   - the printed circuit (2) having a first thermal expansion coefficient ($CTE_{PCB}$) in the plane (X, Y), and
   - an electronic component (5) including at least one terminal (6), each terminal (6) being soldered or sintered only on an associated pad (4) by means of a solder or sintering joint (7), the electronic component (5) comprising two terminals (6), said terminals (6) being separated by a second distance ($L_{CMS}$) when the electronic board (1) is at ambient temperature ($T_1$), the electronic component (5) having a second thermal expansion coefficient ($CTE_{SMC}$) in the plane (X, Y), the solder joint (7) having a third thermal expansion coefficient ($CTE_J$) in the plane (X, Y), wherein each terminal extends above and at a distance from the associated pad (4) along a direction which is normal to the plane (X, Y) and each pad (4) extends on the side of the electronic component, the electronic board being **characterized in that** an orthogonal projection of the terminal (6) of the electronic component (5) on the connection face (3) of the printed circuit does not overlap the associated pad (4).

2. An electronic board (1) according to claim 1, also comprising:

   - an insulating layer (8) covering at least partially the connection face (3),
   - at least one cavity (9) formed in the insulating layer (8) and exposing at least partially the pad (4),

   the electronic component (5) being in contact or at a distance from the insulating layer (8) and the terminal (6) of the electronic component (5) being joined to the corresponding pad (4) through the cavity (9).

3. The electronic board (1) according to claim 2, wherein the printed circuit (2) also comprises at least four conductive layers separated two by two by insulating layers, including:

   - a first skin conductive layer joined to the insulating layer (8),
   - a first and a second internal conductive layers comprising the two pads (4), and
   - at least two cavities (9) formed in the first skin conductive layer and in the insulating layer (8).

4. The electronic board (1) according to one of claims 2 or 3, wherein the wall (10) of the cavity (9) is substantially perpendicular to the pad (4).

5. An electronic board (1) according to one of claims 1 to 4, also comprising an adhesive point (11) under the electronic component (5), between the pads (4), in order to retain the electronic component (5) in position relative to the pads (4) during soldering of the electronic component (5) to the printed circuit (2).

# FIG. 1

# FIG. 2a

## FIG. 2b

## FIG. 3

# FIG. 4

# FIG. 5

## FIG. 6a

## FIG. 6b

## FIG. 7a

## FIG. 7b

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- US 2017150605 A
- US 2015342045 A
- FR 1756700
- FR 1756697